(19) **Europäisches Patentamt / European Patent Office / Office européen des brevets**

(11) **EP 2 433 147 B1**

(12) # EUROPÄISCHE PATENTSCHRIFT

(45) Veröffentlichungstag und Bekanntmachung des Hinweises auf die Patenterteilung:
**05.06.2019 Patentblatt 2019/23**

(21) Anmeldenummer: **10713865.3**

(22) Anmeldetag: **21.04.2010**

(51) Int Cl.:
**G01R 27/18** *(2006.01)* **G01R 31/02** *(2006.01)*

(86) Internationale Anmeldenummer:
**PCT/EP2010/002418**

(87) Internationale Veröffentlichungsnummer:
**WO 2010/133282 (25.11.2010 Gazette 2010/47)**

(54) **VERFAHREN UND EINRICHTUNG ZUR ISOLATIONSÜBERWACHUNG VON UNGEERDETEN ELEKTRISCHEN GLEICH- UND WECHSELSTROMNETZEN**

METHOD AND APPARATUS FOR INSULATION MONITORING OF UNEARTHED ELECTRICAL DC- AND AC-POWER NETWORKS

PROCÉDÉ ET PROCESSUS POUR LA SURVEILLANCE DE L'ISOLATION DANS DES RÉSEAUX CONTINUS ET ALTERNATIFS NON MIS À LA TERRE

(84) Benannte Vertragsstaaten:
**AT BE BG CH CY CZ DE DK EE ES FI FR GB GR HR HU IE IS IT LI LT LU LV MC MK MT NL NO PL PT RO SE SI SK SM TR**

(30) Priorität: **19.05.2009 DE 102009022003**
**05.10.2009 DE 102009048294**

(43) Veröffentlichungstag der Anmeldung:
**28.03.2012 Patentblatt 2012/13**

(73) Patentinhaber: **ABB AG**
**68309 Mannheim (DE)**

(72) Erfinder:
• **BRENK, Frank**
**77756 Hausach (DE)**
• **WITTE, Franz-Otto**
**79331 Teningen (DE)**
• **STREPP, Wolfram**
**79100 Freiburg (DE)**

(56) Entgegenhaltungen:
**EP-A1- 0 654 673 DE-C1- 10 106 200**

• **Aditi Rathi: "insulation Monitoring and Earth Fault Detection in 3 Phase 3 Wire Unearthed Systems" 1. März 2007 (2007-03-01), Seiten 1-4, XP002596526 Internet Gefunden im Internet: URL:http://www.Intebg.com/news/upload/curr enttrends/2007%20Jan-Mar.pdf [gefunden am 2010-08-11]**
• **BRUIJNEN D; VAN DE MOLENGRAFT R; STEINBUCH M: "Efficient IIR notch filter design via multirate filtering targeted at harmonic disturbance rejection" MECHATRONICS 2006. 4TH IFAC SYMPOSIUM ON MECHATRONIC SYSTEMS. PREPRINTS 2006 VDI/VDE-GESELLSCHAFT MESS- UND AUTOMATISIERUNGSTECHNIK, [Online] 2006, Seiten 318-323, XP002596527 DUESSELDORF, GERMANY Gefunden im Internet: URL:http://www.mate.tue.nl/mate/pdfs/6588. pdf> [gefunden am 2010-08-13]**

EP 2 433 147 B1

## Beschreibung

Die Erfindung betrifft ein Verfahren zur Isolationsüberwachung von ungeerdeten elektrischen Gleichstromnetzen und Wechselstromnetzen, die einen unvermeidbaren ohmschen sowie kapazitiven Isolationswiderstand zwischen Netz und Erde aufweisen, insbesondere solche mit angeschlossenen Gleichrichtern und sonstigen Stromrichtern, bei dem eine abwechselnd verschiedene Impulsspannungswerte aufweisenden Impulswechselspannung über eine ohmsche Netzankopplung zwischen Netz und Erde an das zu überwachende Netz angelegt wird, wobei für jeden Impulsspannungswert der zeitliche Verlauf des vom momentanen Netz abhängigen Einschwingvorgangs des Messstroms oder einer hiervon abgeleiteten Größe als Messspannung überwacht wird, gemäß dem Oberbegriff des Anspruchs 1.

Die Erfindung betrifft weiter eine Einrichtung zur Isolationsüberwachung von ungeerdeten elektrischen Gleichstromnetzen und Wechselstromnetzen, die einen ohmschen sowie kapazitiven Isolationswiderstand zwischen Netz und Erde aufweisen, umfassend eine Impulswechselspannungsquelle zum Anlegen einer abwechselnd verschiedene Impulsspannungswerte aufweisende Impulswechselspannung über eine ohmsche Netzankopplung zwischen Netz und Erde an das zu überwachende Netz, und mit einer Überwachungsvorrichtung zur Überwachung des zeitlichen Verlaufs des vom momentanen Netz abhängigen Einschwingvorgangs des Messstroms oder einer hiervon abgeleiteten Größe als Messspannung für jeden Impulsspannungswert, gemäß dem Oberbegriff von Anspruch 10.

Ein gattungsgemäßes Verfahren wird beispielsweise in der EP 0 654 673 B1 beschrieben. Bei bekannten Messverfahren muss für die Auswertung der Messung ein stabiler eingeschwungener Zustand des Messstroms oder einer hiervon abgeleiteten Größe als Messspannung erreicht werden. Erst nach Erreichen des eingeschwungenen Zustands werden die Messwerte zur Ermittlung des Isolationswiderstandes herangezogen. Vorherige Messwerte bleiben unberücksichtigt. Dies bedingt eine lange Messzeit, die unerwünscht ist. Durch eine lange Messzeit steigt die Wahrscheinlichkeit von Änderungen des Isolationswiderstandes im Netz durch Schaltvorgänge. Weiterhin birgt jede zeitliche Verzögerung der Erkennung einer gefährlich niedrigen Netzisolation ein zusätzliches Gefahrenpotenzial und ist daher zu vermeiden. In der EP 0 654 673 B1 wird bei der Erfassung und Auswertung der Messspannung eine Mittelwertbildung in Form eines arithmetischen Mittelwertes verwendet.

Ein ähnliches Verfahren ist aus DE10106200 bekannt.

Der vorliegenden Erfindung liegt im Lichte des Standes der Technik daher die Aufgabe zugrunde, ein gattungsgemäßes Verfahren so weiterzuentwickeln, dass die Messzeit verkürzt ist. Eine weitere Aufgabe der Erfindung ist es, eine verbesserte Einrichtung zur Isolationsüberwachung bereitzustellen.

Die der Erfindung zugrundeliegende Aufgabe wird bezüglich des Verfahrens erfindungsgemäß gelöst durch ein gattungsgemäßes Verfahren mit den kennzeichnenden Merkmalen des Anspruchs 1. Bezüglich der Einrichtung wird die Aufgabe gelöst durch Anspruch 10.

Erfindungsgemäß werden die zeitlichen Verläufe der Einschwingvorgänge der Messspannung vor dem Einschwingen des Netzes auf den jeweiligen Impulsspannungswert zweier in der Polarität invertierter Impulsspannungswert-Anlegevorgänge zur Ermittlung des Isolationswiderstandes zwischen Netz und Erde herangezogen. Der Vorteil des erfindungsgemäßen Verfahrens liegt darin, dass der Isolationswiderstand damit schneller ermittelt werden kann, da nicht mehr auf das Erreichen des eingeschwungenen Zustandes gewartet werden muss. Der Wert der Messspannung wird nach wie vor für den eingeschwungenen Zustand ermittelt. Doch wird der eingeschwungene Wert im eingeschwungenen Zustand aus den zeitlichen Verläufen der Einschwingvorgänge bereits zu einem früheren Zeitpunkt vorausgesagt, wenn der eingeschwungene Zustand tatsächlich noch gar nicht erreicht ist.

Gemäß einer vorteilhaften Ausführungsform der Erfindung sind die zwei in der Polarität invertierten Impulsspannungswert-Anlegevorgänge zeitlich aufeinanderfolgend. Damit wird eine zügige Durchführung der Messung gewährleistet.

Gemäß der Erfindung wird der gemessene zeitliche Verlauf des Einschwingvorgangs der Messspannung vor dem Einschwingen des Netzes zur Schätzung von Modellparametern eines berechneten zeitlichen Verlaufs des Einschwingvorgangs herangezogen, und der Isolationswiderstand wird aus einem Modellparameter ermittelt. Der Vorteil bei dieser erfindungsgemäßen Vorgehensweise liegt darin, dass die Messung bereits vor Erreichen des eingeschwungenen Zustandes abgebrochen werden kann, da der gesuchte Wert des Isolationswiderstandes nicht aus dem Messwert, sondern aus einem Parameter eines Modells ermittelt wird. Dies eröffnet die Möglichkeit, mittels des Modells den eingeschwungenen Zustand zu einem frühen Zeitpunkt schon theoretisch vorherzusagen und daraus dann den Isolationswiderstand zu ermitteln, wobei dieser Zeitpunkt früher liegt als das tatsächliche erreichen des eingeschwungenen Zustandes.

Gemäß einer vorteilhaften Ausführungsform der Erfindung werden während des Einschwingvorgangs vor Erreichen des eingeschwungenen Zustandes die Modellparameter so lange variiert, bis die Abweichung des gemessenen von dem errechneten zeitlichen Verlauf des Einschwingvorgangs der Messspannung eine vorgebbare Schwelle unterschreitet. Das Modell ist dann so gut an den realen Einschwingvorgang angepasst, dass es die Werte der Modellparameter für Zeitpunkte in der Zukunft mit einer sehr hohen Sicherheit vorhersagt und damit der Isolationswiderstand im eingeschwungenen Zustand aus dem Modell berechnet werden kann. Der eingeschwungene Zustand wird gewissermaßen anhand eines Modells prognostiziert.

Gemäß einer vorteilhaften Ausführungsform der Erfindung wird der gemessene zeitliche Verlauf des Einschwingvorgangs der Messspannung durch Multiratenfilterung mit rekursiven Dezimationsfiltern gefiltert. Dadurch werden störende hochfrequente Signalanteile aus dem Signal entfernt, so dass der Vergleich mit den aus dem Modell berechneten Werten weniger fehlerbehaftet ist.

Gemäß einer vorteilhaften Ausführungsform der Erfindung wird die Abweichung des gemessenen von dem errechneten zeitlichen Verlauf des Einschwingvorgangs der Messspannung zwischen den Abtastpunkten des gemessenen Verlaufs nach der Methode der kleinsten Fehlerquadrate minimiert.

Gemäß einer vorteilhaften Ausführungsform der Erfindung wird in einer ersten Dezimationsstufe zur Ausfilterung hochfrequenter Signalanteile das Eingangssignal in der Abtastrate herabgesetzt, beispielsweise um den Faktor 4. Dadurch werden hochfrequente Signalanteile gut entfernt und die erforderliche Rechenleistung reduziert, ohne das Messergebnis zu verändern.

Gemäß einer vorteilhaften Ausführungsform der Erfindung wird nach der ersten Dezimationsstufe ein Notch-Filter zur Unterdrückung der Wechselkomponente der Netzspannung vorgesehen. Die Netzspannung kann dabei unabhängig gemessen und über einen separaten Signaleingang eingespeist werden.

Gemäß einer vorteilhaften Ausführungsform der Erfindung wird in einer zweiten Dezimationsstufe die Abtastfrequenz zu einer weiteren Signalglättung weiter reduziert. Dadurch wird der Rechenaufwand für die Auswertung reduziert und eine weitere Signalglättung erreicht.

Gemäß einer vorteilhaften Ausführungsform der Erfindung werden zur weiteren Unterdrückung der Netzfrequenz weitere Notch-Filter eingesetzt.

Gemäß einer vorteilhaften Ausführungsform der Erfindung wird zur weiteren Störungsunterdrückung der zweite Impulsspannungswert-Anlegevorgang phasensynchron zur Netzfrequenz gestartet.

Eine erfindungsgemäße Einrichtung ist dadurch gekennzeichnet, dass die Einrichtung eine Messeinrichtung zum Erfassen der zeitlichen Verläufe der Einschwingvorgänge der Messspannung vor dem Einschwingen des Netzes auf den jeweiligen Impulsspannungswert zweier in der Polarität invertierter Impulsspannungswert-Anlegevorgänge, und eine Vorrichtung zur Parameterschätzung von Modellparametern eines berechneten zeitlichen Verlaufs des Einschwingvorgangs der Messspannung zur Ermittlung des Isolationswiderstandes zwischen Netz und Erde aus einem Parameter des Modells umfasst.

Die vorliegende Erfindung stellt also ein Verfahren und eine Einrichtung bereit, bei dem der Verlauf der Messspannung während des Einschwingvorgangs untersucht wird und zur Schätzung von Systemparametern herangezogen wird. Die Messspannung während des Einschwingvorgangs wird dabei nicht gemittelt, sondern durch Multiratenfilterung mit rekursiven Dezimationsfiltern von hochfrequenten Signalanteilen befreit. Dadurch können Artefakte, die bei einer einfachen, beispielsweise gleitenden, Mittelwertbildung gemäß dem Stand der Technik auftreten können, vollständig vermieden werden.

Durch die Schätzung der Systemparameter entfällt die Notwendigkeit, bis zum Abklingen des Einschwingvorganges warten zu müssen. Da insbesondere bei hohen Kapazitäten des Netzes gegenüber der Erde die Zeit des Einschwingvorgangs in den Bereich von mehreren 10 Sekunden gehen kann, kann durch das erfindungsgemäße Verfahren eine beträchtliche Beschleunigung erzielt werden.

Weitere vorteilhafte Ausgestaltungen und Verbesserungen der Erfindung und weitere Vorteile sind den Unteransprüchen zu entnehmen.

Figurenbeschreibung

Figuren und Beschreibung dienen dem besseren Verständnis des Gegenstands. Gegenstände oder Teile von Gegenständen, die im Wesentlichen gleich oder ähnlich sind, können mit denselben Bezugzeichen versehen sein. Die Figuren sind lediglich eine schematische Darstellung einer Ausführungsform der Erfindung.

Dabei zeigen:

Fig. 1    ein elektrisches Ersatzschaltbild zur Ermittlung der Messspannung, und

Fig. 2    eine Darstellung des Funktionsablaufs der Parameterschätzung.

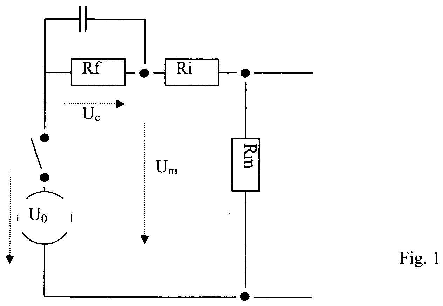

Dem erfindungsgemäßen Verfahren liegt ein in der Fig. 1 gezeigtes Ersatzschaltbild für die Messschaltung zugrunde. Dabei bezeichnet $R_f$ den ohmschen Anteil des Isolationswiderstandes der zu überwachenden Leitung zwischen Netz und Erde, $C_f$ bezeichnet den kapazitiven Anteil des Isolationswiderstandes der zu überwachenden Leitung zwischen Netz und Erde, $U_0$ ist die Spannungsquelle, mit der die verschiedene Impulsspannungswerte liefernde Impulswechselspannung aufgeprägt wird, $R_i$ ist der Innenwiderstand der ohmschen Netzankopplung der Impulswechselspannung $U_0$, $R_m$ ist ein Messwiderstand. Das Ziel des Verfahrens ist es, $R_f$ zu bestimmen.

Eine Schaltungsanalyse der obigen vereinfachten Schaltung unter Berücksichtigung des Anfangsladezustandes des Kondensators $C_f$ ergibt folgenden Zusammenhang für den zeitlichen Verlauf der Messspannung $V_m$, die über der Serienschaltung von $R_i$ und $R_m$ abfällt:

$$UmD(t) = \frac{U_0}{1+K} + (\frac{U_0}{1+K} - U_{C0})e^{\frac{-(1+K)t}{\tau}}$$

Hierbei gilt:

$$K = \frac{R_f}{R_m + R_i}, \qquad \tau = R_f C_f, \qquad U_{c0} = Anfangsspannung\ von\ C_f$$

Interpretiert man diesen Zusammenhang, so fällt auf, dass die Ausgangsspannung UmD zu einem Endwert

$$O = \frac{U_0}{1+K}$$

hin konvergiert. Dies ist der Wert im eingeschwungenen Zustand. Der Anfangswert hängt vom Ladezustand der Netzkapazität gegen Erde $U_{c0}$ und dem Endwert O ab. Die Terme der oben aufgeführte Gleichung können auch wie folgt sortiert werden:

$$V_m = \frac{U_0}{1+K} + (\frac{U_0}{1+K} - U_{c0}\ e^{\frac{-(1+K)t}{\tau}}$$

Im Ergebnis erhält man also einen Einschwingvorgang, der von den Konstanten O,

$$A = \frac{U_0}{1+K} - U_{c0}$$

und

$$\lambda = \frac{(1+K)}{\tau}$$

abhängt.

Als Modell für den prinzipiellen Verlauf der Messspannung kann man demzufolge den folgenden Ausdruck heranziehen:

$$UmD(t) = O + Ae^{-\lambda t} \quad (0)$$

Die Ladespannung des Kondensators $U_{c0}$ ist bei dem vorgegebenen Messprinzip als eine negative Größe anzusetzen, da im Allgemeinen eine Vorladung aus dem vorhergehenden Halbzyklus mit negativer Polarität verbleibt.

Dieser Kurvenverlauf entspricht dem ungefilterten und geglätteten Messsignal. Der Einfluss der Glättung entspricht im Wesentlichen einer Faltung mit der Stoßantwort des Glättungsfilters $H(z) = \sum_{k=0}^{+\infty} h_k z^{-k}$ mit den Koeffizienten $h_k$. Die geglättete Messspannung $V_{mD}$ kann so-mit durch folgenden Ausdruck beschrieben werden.

$$VmD(t_k, \lambda, O, A) = \sum_{i=-\infty}^{+\infty} UmD(t_i, \lambda, O, A) \cdot h_{k-i} \qquad (1)$$

Der gemessene Kuvenverlauf wird mit einem modellierten Kurvenverlauf verglichen. Als Ergebnis dieses Vergleichs werden die Kenngrößen $\lambda$, O und A eines theoretischen Kurvenverlaufs ermittelt.

Eine Möglichkeit zur Ermittlung der Kenngrößen ist die Verwendung der Methode der kleinsten Quadrate, die im Folgenden beschrieben wird.

Die Aufgabe ist, die Parameter $\lambda$, O und A so zu bestimmen, dass der gefilterte theoretische Verlauf $VmD(t_k, \lambda, O, A)$ möglichst gut mit den gemessenen Werten $VmD_k$ übereinstimmt. Beim erwähnten Verfahren der kleinsten Quadrate wird der Fehler zwischen den Abtastpunkten der gemessenen und der Modellkurve minimiert. Dies geschieht durch folgenden Ausdruck:

$$E = \sum_{k=1}^{n} dy_k{}^2 \qquad (2)$$

Dabei ist:

$$dy_k = VmD_k - VmD(t_k, \lambda, O, A)$$

Durch Ableiten von E nach den Parametern $\lambda$, O und A, und durch Gleichsetzen dieser Ableitungen mit 0, bekommt man schließlich folgende Formel:

$$\begin{pmatrix} d\lambda \\ dO \\ dA \end{pmatrix} = (H^t H)^{-1} H^t \begin{pmatrix} dy_1 \\ \vdots \\ dy_n \end{pmatrix} \qquad (3)$$

Dabei ist H die Jacobi-Matrix:

$$H(\lambda, O, A) = \begin{pmatrix} \dfrac{\partial VmD(t_1, \lambda, O, A)}{\partial \lambda} & \dfrac{\partial VmD(t_1, \lambda, O, A)}{\partial O} & \dfrac{\partial VmD(t_1, \lambda, O, A)}{\partial A} \\ \vdots & \vdots & \vdots \\ \dfrac{\partial VmD(t_n, \lambda, O, A)}{\partial \lambda} & \dfrac{\partial VmD(t_n, \lambda, O, A)}{\partial O} & \dfrac{\partial VmD(t_n, \lambda, O, A)}{\partial A} \end{pmatrix} \qquad (4)$$

Die in Gl. (4) auftretenden Ableitungen können über Gl. (1) bestimmt werden, z.B. ist:

$$\frac{\partial VmD(t_n, \lambda, O, A)}{\partial \lambda} = \sum_{i=-\infty}^{+\infty} \frac{\partial UmD(t_i, \lambda, O, A)}{\partial \lambda} \cdot h_{n-i}$$

Mit anderen Worten: um die in Gl. (4) auftretenden Terme zu berechnen, kann man einfach die Ableitungen von Gl. (0) durch den digitalen Filter schicken.

Die Ableitungen sind im einzelnen:

$$\frac{\partial UmD(t,\lambda,O,A)}{\partial \lambda} = -t \cdot A \cdot e^{-\lambda t}$$

$$\frac{\partial UmD(t,\lambda,O,A)}{\partial O} = 1 \qquad\qquad (5)$$

$$\frac{\partial UmD(t,\lambda,O,A)}{\partial A} = e^{-\lambda t}$$

Man kann sich den in diesen Ableitungen und in Gl. (0) vorkommenden Faktor $e^{-\lambda t}$ leicht iterativ berechnen. Wenn immer derselbe Zeitschritt $\Delta t = t_{i+1} - t_i$ gemacht wird, ist:

$$e^{-\lambda t_{i+1}} = e^{-\lambda t_i} \cdot e^{-\lambda \Delta t}$$

Der Faktor $e^{-\lambda \Delta t}$ muss nur einmal berechnet werden.

Die Matrix-Multiplikationen in Gl. (3) unterteilt man zweckmäßig in zwei Terme, wobei der erste:

$$H^t H$$

eine 3x3-Matrix ist, und der zweite:

$$H^t \begin{pmatrix} dy_1 \\ \vdots \\ dy_n \end{pmatrix}$$

eine 3x1-Matrix. Die Invertierung des ersten Terms ist noch ohne größeren Aufwand machbar.

In gewissen Situationen, z.B. der Fabrik-Kalibration, ist die Netzableitkapazität Null, so dass der Kurvenverlauf von Gl. (0) zu einer Konstanten wird:

$$UmD(t_i) = O$$

Dadurch verschwinden in Gl. (5) die Ableitungen nach $\lambda$ und A, und die Sache vereinfacht sich deutlich, weil die beiden oben erwähnten Terme zu 1x1-Matrizen werden.

Das beschriebene Verfahren arbeitet iterativ und benötigt zur Konvergenzbeschleunigung sinnvolle Startwerte $\lambda_0$, $O_0$ und $A_0$. Ergebnis der Formel (3) sind Korrekturwerte dA, dO und dA, aus denen sich neue Startwerte für den nächsten Durchlauf ergeben:

$$\begin{pmatrix} \lambda_1 \\ O_1 \\ A_1 \end{pmatrix} = \begin{pmatrix} \lambda_0 \\ O_0 \\ A_0 \end{pmatrix} + \begin{pmatrix} d\lambda \\ dO \\ dA \end{pmatrix}$$

Wenn die Korrekturwerte d$\lambda$, dO und dA so klein sind, dass sich keine nennenswerten Veränderungen mehr für $\lambda$, O und A ergeben, kann man das Verfahren beenden.

Über Gleichung (2) ergibt sich dann der (minimierte) Fehler $E_{min}$, der ein Maß dafür ist, wie gut die Messwerte zum theoretischen Kurvenverlauf passen. Wenn sich z.B. während der Messdauer eine starke DC-Änderung ereignet, wird sich $E_{min}$ vergrößern, so dass dieser Wert eine Beurteilung der ,Qualität' der Messung erlaubt.

Hier können zudem bekannte Verfahren zur Konvergenzbeschleunigung eingesetzt werden, wie das Levenberg-Marquardt Verfahren.

Das oben beschriebene Verfahren funktioniert, wenn die Startwerte in der Nähe des gesuchten Minimums von Gl.(2) sind.

Da es nur ein Minimum gibt, kann man auch die Methode des 'steilsten Abstiegs', benutzen, wo sich die Korrekturwerte ergeben aus:

$$\begin{pmatrix} d\lambda \\ dO \\ dA \end{pmatrix} = N^{-1} H^{t} \begin{pmatrix} dy_1 \\ \vdots \\ dy_n \end{pmatrix}$$

mit

$$N_{ij} = (H^t H)_{ij} (1 + m \cdot \delta_{ij})$$

wobei $\delta_{ij}$ das Kronecker-Symbol ist, und m ein Parameter > 0. Für m = 0 ergibt sich das im vorigen Abschnitt beschriebene Verfahren, für große m geht es in die Methode des steilsten Abstiegs (bzw. eine Variante davon: Marquardt) über.

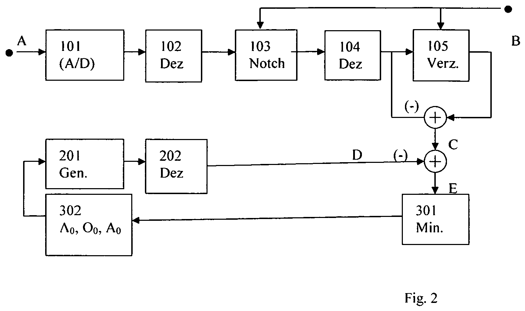

Das Gesamtverfahren lässt sich anhand des in der Fig. 2 dargestellten Ablaufschemas veranschaulichen: Die analoge Messspannung $V_m$, eingespeist in Punkt A, durchläuft zunächst einen Analog/Digitalwandler 101. Die Abtastung erfolgt bei einer relativ hohen Abtastfrequenz, bei ca. 2500 Hz. In einer ersten Dezimationsstufe 102 wird das Eingangssignal in der Abtastrate um einen Faktor z.B. 4 herabgesetzt. Dabei werden die hochfrequenten Signalanteile eliminiert. Ein weiterer Vorteil der Dezimation ist, dass sich hierdurch die effektive Auflösung des Signals bei jeder Halbierung der Abtastfrequenz um bis zu 3dB verbessert. Bei einer Reduktion der Abtastrate um den Faktor 2^2=4 kann im Idealfall eine S/N Erhöhung von bis zu 6dB = 1Bit erreicht werden.

Nach den ersten Dezimation unterdrückt ein Notchfilter 103 die Wechselkomponente der Netzspannung des Netzes, wobei die Netzperiode in einem unabhängigen Zweig gemessen wird und über den Signaleingang B eingespeist wird.

Eine zweite Dezimationsstufe 104 reduziert die Abtastfrequenz weiter, um den erforderlichen Rechenaufwand für die Auswertungsstufen zu reduzieren und eine weitere Signalglättung zu erhalten.

Der Einschwingvorgang für negativen Halbwelle des Generatorsignals wird an der Summierungsstelle C vom in einer Verzögerungsstufe 105 zeitverzögerten Signal der negativen Halbwelle abgezogen, wodurch sich die Amplitude des Messsignals verdoppelt. Wenn der Startpunkt der negativen Halbwelle zudem soweit verzögert wird, dass er dem nächsten ganzzahligen Vielfachen der Netzperiode entspricht, werden durch die Differenzbildung verbleibende Störkomponenten der Netzspannung eliminiert.

Vom so generierten Differenzsignal wird in einer Summierungsstelle E ein modellierter Kurvenverlauf D abgezogen, der vom Generator 201 und dessen Verlauf ebenfalls durch ein Dezimationsfilter 202 geleitet wird. Die Differenz wird mit Hilfe einer Vorrichtung 301 zur Parameterschätzung, verarbeitet, welche einen verbesserten Satz der drei gesuchten Kurvenparameter $\Lambda_0$, $O_0$, $A_0$ liefert, welche im Block 302 dem modellierten Kurvenverlauf zugrundegelegt werden.

Der zuletzt beschriebene Vorgang wird einige Male iteriert, bis eine ausreichende Genauigkeit der Schätzparameter $\Lambda$, O, A erreicht ist.

Aus dem Parameter O kann anschließend durch einfache Umrechnung der Wert des Ableitwiderstandes $R_f$ errechnet werden.

Die eingesetzten Glättungsverfahren arbeiten sehr gut. Bei geringen Erdschlusswiderständen kann jedoch die Netzfrequenz sehr stark mit der Messung wechselwirken. Um dies zu verhindern, können zusätzlich Notchfilter eingesetzt werden.

Eine weitere Verbesserung des hier vorgestellten Verfahrens kann durch die Unterdrückung von Störungen durch Synchronisierung der Startzeit der zweiten Messperiode erreicht werden. Die zweite Messperiode, die zweite Halbwelle der aufgeprägten Wechselspannung, wird dabei phasensynchron zur Netzfrequenz gestartet. Durch diese synchrone Verzögerung liegen Netzfrequenzen in beiden Messperioden zeitsynchron übereinander. Bei der anschließenden Auswertung des Einschwingvorgangs kann der Einfluss der Netzfrequenz durch die Differenzbildung von korrespondierenden Einschwingwerten deutlich reduziert werden, wobei der Grad der Unterdrückung lediglich von der Konstanz der Netzfrequenz und der Genauigkeit der Signalverzögerung abhängig ist.

**Patentansprüche**

1. Verfahren zur Isolationsüberwachung von ungeerdeten elektrischen Gleichstromnetzen und Wechselstromnetzen, die einen ohmschen ($R_f$) sowie kapazitiven ($C_f$) Isolationswiderstand zwischen Netz und Erde aufweisen, bei dem

eine abwechseln verschiedene Impulsspannungswerte aufweisende Impulswechselspannung ($U_0$) über eine ohmsche Netzankopplung ($R_i$) zwischen Netz und Erde an das zu überwachende Netz angelegt wird, wobei für jeden Impulsspannungswert ($U_0$) der zeitliche Verlauf des vom momentanen Netz abhängigen Einschwingvorgangs des Messstroms oder einer hiervon abgeleiteten Größe als Messspannung ($V_m$) überwacht wird, wobei die zeitlichen Verläufe der Einschwingvorgänge der Messspannung ($V_m$) vor dem Einschwingen des Netzes auf den jeweiligen Impulsspannungswert ($U_0$) zweier in der Polarität invertierter Impulsspannungswert-Anlegevorgänge zur Ermittlung des Isolationswiderstandes ($R_f$) zwischen Netz und Erde herangezogen werden, **dadurch gekennzeichnet, dass** der gemessene zeitliche Verlauf des Einschwingvorgangs der Messspannung ($V_m$) vor dem Einschwingen des Netzes zur Schätzung von Modellparametern eines berechneten zeitlichen Verlaufs des Einschwingvorgangs herangezogen wird und der Isolationswiderstand aus einem Modellparameter ermittelt wird.

2.  Verfahren nach Anspruch 1,
    **dadurch gekennzeichnet, dass** die zwei in der Polarität invertierten Impulsspannungswert-Anlegevorgänge zeitlich aufeinanderfolgend sind.

3.  Verfahren nach Anspruch 1,
    **dadurch gekennzeichnet, dass** während des Einschwingvorgangs vor Erreichen des eingeschwungenen Zustandes die Modellparameter so lange variiert werden, bis die Abweichung des gemessenen von dem errechneten zeitlichen Verlauf des Einschwingvorgangs der Messspannung eine vorgebbare Schwelle unterschreitet.

4.  Verfahren nach Anspruch 1,
    **dadurch gekennzeichnet, dass** der gemessene zeitliche Verlauf des Einschwingvorgangs der Messspannung $V_m$ durch Multiratenfilterung mit rekursiven Dezimationsfiltern gefiltert wird.

5.  Verfahren nach Anspruch 1,
    **dadurch gekennzeichnet, dass** die Abweichung des gemessenen von dem errechneten zeitlichen Verlauf des Einschwingvorgangs der Messspannung zwischen den Abtastpunkten des gemessenen Verlaufs nach der Methode der kleinsten Fehlerquadrate minimiert wird.

6.  Verfahren nach Anspruch 4,
    **dadurch gekennzeichnet, dass** in einer ersten Dezimationsstufe zur Ausfilterung hochfrequenter Signalanteile das Eingangssignal in der Abtastrate herabgesetzt wird.

7.  Verfahren nach Anspruch 6,
    **dadurch gekennzeichnet, dass** nach der ersten Dezimationsstufe ein Notch-Filter zur Unterdrückung der Wechselkomponente der Netzspannung vorgesehen wird.

8.  Verfahren nach Anspruch 7,
    **dadurch gekennzeichnet, dass** in einer zweiten Dezimationsstufe die Abtastfrequenz zu einer weiteren Signalglättung weiter reduziert wird.

9.  Verfahren nach Anspruch 8,
    **dadurch gekennzeichnet, dass** zur weiteren Unterdrückung der Netzfrequenz weitere Notch-Filter eingesetzt werden.

10. Einrichtung zur Isolationsüberwachung von ungeerdeten elektrischen Gleichstromnetzen und Wechselstromnetzen, die einen ohmschen ($R_f$) sowie kapazitiven ($C_f$) Isolationswiderstand zwischen Netz und Erde aufweisen, umfassend eine Impulswechselspannungsquelle zum Anlegen einer abwechselnd verschiedene Impulsspannungswerte aufweisende Impulswechselspannung ($U_0$) über eine ohmsche Netzankopplung ($R_i$) zwischen Netz und Erde an das zu überwachende Netz, und mit einer Überwachungsvorrichtung zur Überwachung des zeitlichen Verlaufs des vom momentanen Netz abhängigen Einschwingvorgangs des Messstroms oder einer hiervon abgeleiteten Größe als Messspannung ($V_m$) für jeden Impulsspannungswert ($U_0$),
    **dadurch gekennzeichnet, dass** die Einrichtung umfasst

    - eine Messeinrichtung zum Erfassen der zeitlichen Verläufe der Einschwingvorgänge der Messspannung ($V_m$) vor dem Einschwingen des Netzes auf den jeweiligen Impulsspannungswert ($U_0$) zweier in der Polarität invertierter Impulsspannungswert-Anlegevorgänge, und
    - eine Vorrichtung zur Parameterschätzung von Modellparametern eines berechneten zeitlichen Verlaufs des

Einschwingvorgangs der Messspannung ($V_m$) zur Ermittlung des Isolationswiderstandes ($R_f$) zwischen Netz und Erde aus einem Parameter des Modells.

11. Einrichtung nach Anspruch 10, **dadurch gekennzeichnet, dass** die Messeinrichtung eine Filtervorrichtung zur Durchführung einer Multiratenfilterung mit rekursiven Dezimationsfiltern umfasst.

12. Einrichtung nach Anspruch 11, **dadurch gekennzeichnet, dass** die Filtereinrichtung eine erste Dezimationsstufe, ein Notchfilter und eine zweite Dezimationsstufe umfasst.

**Claims**

1. Method for insulation monitoring of non-grounded electrical DC power supply systems and AC power supply systems which have a resistive ($R_f$) and capacitive ($C_f$) insulation impedance between the power supply system and ground, in which a pulsed AC voltage ($U_0$) having alternately different pulsed voltage values is applied to the power supply system to be monitored via a resistive system interface ($R_i$) between the power supply system and ground, wherein the time profile of the transient process of the measurement current, which is dependent on the instantaneous power supply system, or a variable derived therefrom as measurement voltage ($V_m$) is monitored for each pulsed voltage value ($U_0$), wherein the time profiles of the transient processes of the measurement voltage ($V_m$) prior to the transient recovery of the power supply system to the respective pulsed voltage value ($U_0$) of two polarity-inverted pulsed voltage value application processes are used for determining the insulation impedance ($R_f$) between the power supply system and ground, **characterized in that** the measured time profile of the transient process of the measurement voltage ($V_m$) prior to the transient recovery of the power supply system is used to estimate model parameters for a calculated time profile of the transient process and the insulation impedance is determined from a model parameter.

2. Method according to Claim 1, **characterized in that** the two polarity-inverted pulsed voltage value application processes are successive in time.

3. Method according to Claim 1, **characterized in that**, during the transient process prior to reaching the settled state, the model parameters are varied until the discrepancy between the measured and the calculated time profile of the transient process of the measurement voltage falls below a predeterminable threshold.

4. Method according to Claim 1, **characterized in that** the measured time profile of the transient process of the measurement voltage $V_m$ is filtered by means of multirate filtering with recursive decimation filters.

5. Method according to Claim 1, **characterized in that** the discrepancy between the measured and the calculated time profile of the transient process of the measurement voltage between the sampling points of the measured profile is minimized in accordance with the method of least squares.

6. Method according to Claim 4, **characterized in that**, in a first decimation stage for filtering out radiofrequency signal components, the sampling rate of the input signal is stepped down.

7. Method according to Claim 6, **characterized in that**, after the first decimation stage, a notch filter for suppressing the AC component of the system voltage is provided.

8. Method according to Claim 7, **characterized in that**, in a second decimation stage, the sampling frequency is further reduced for further signal smoothing.

9. Method according to Claim 8, **characterized in that** further notch filters are used for further suppression of the system frequency.

10. Device for insulation monitoring of non-grounded electrical DC power supply systems and AC power supply systems which have a resistive ($R_f$) and capacitive ($C_f$) insulation impedance between the power supply system and ground, comprising a pulsed AC voltage source for applying a pulsed AC voltage ($U_0$) having alternately different pulsed voltage values to the power supply system to be monitored via a resistive system interface ($R_i$) between the power supply system and ground, and with a monitoring apparatus for monitoring the time profile of the transient process of the measurement current, which is dependent on the instantaneous power supply system, or a variable derived therefrom as measurement voltage ($V_m$) for each pulsed voltage value ($U_0$), **characterized in that** the device comprises:

- a measuring device for detecting the time profiles of the transient processes of the measurement voltage ($V_m$) prior to the transient recovery of the power supply system to the respective pulsed voltage value ($U_0$) of two polarity-inverted pulsed voltage value application processes, and
- an apparatus for parameter estimation of model parameters of a calculated time profile of the transient process of the measurement voltage ($V_m$) for determining the insulation impedance ($R_f$) between the power supply system and ground from a parameter of the model.

**11.** Device according to Claim 10, **characterized in that** the measuring device comprises a filter apparatus for implementing multirate filtering with recursive decimation filters.

**12.** Device according to Claim 11, **characterized in that** the filter device comprises a first decimation stage, a notch filter and a second decimation stage.

**Revendications**

**1.** Procédé de surveillance de l'isolement de réseaux électriques à courant continu et à courant alternatif non reliés à la terre qui présentent une résistance d'isolement ohmique ($R_f$) et capacitive ($C_f$) entre le réseau et la terre, selon lequel une tension alternative impulsionnelle ($U_0$) qui présente en alternance différentes valeurs de tension impulsionnelle est appliquée au réseau à surveiller par l'intermédiaire d'un couplage de réseau ohmique ($R_i$) entre le réseau et la terre, dans lequel, pour chaque valeur de tension impulsionnelle ($U_0$), la variation dans le temps du processus transitoire, qui dépend du réseau instantané, du courant de mesure ou d'une grandeur qui en découle, est surveillée en tant que tension de mesure ($V_m$), dans lequel les variations dans le temps des processus transitoires de la tension de mesure ($V_m$) sont prises en compte pour la détermination de la résistance d'isolement ($R_f$) entre le réseau et la terre avant la transition du réseau à la valeur de tension impulsionnelle ($U_0$) respective de deux processus d'application de valeurs de tension impulsionnelle à polarité inversée, **caractérisé en ce que** la variation dans le temps mesurée du processus transitoire de la tension de mesure ($V_m$) est prise en compte pour l'estimation de paramètres de modèle d'une variation dans le temps calculée du processus transitoire, et **en ce que** la résistance d'isolement est déterminée à partir d'un paramètre du modèle.

**2.** Procédé selon la revendication 1,
**caractérisé en ce que** les deux processus d'application de la valeur de tension impulsionnelle à polarité inversée se suivent dans le temps.

**3.** Procédé selon la revendication 1,
**caractérisé en ce que**, pendant le processus transitoire, les paramètres du modèle sont modifiés avant que l'état transitoire soit atteint, jusqu'à ce que l'écart entre les variations dans le temps mesurée et calculée du processus transitoire de la tension de mesure s'abaisse en-dessous d'un seuil pouvant être prédéterminé.

**4.** Procédé selon la revendication 1,
**caractérisé en ce que** la variation dans le temps mesurée du processus transitoire de la tension de mesure $V_m$ est filtrée par filtrage à cadences multiples au moyen de filtres de décimation récursifs.

**5.** Procédé selon la revendication 1,
**caractérisé en ce que** l'écart entre les variations dans le temps mesurée et calculée du processus transitoire de la tension de mesure entre les points d'échantillonnage de la variation mesurée est minimisé par la méthode des moindres carrés.

**6.** Procédé selon la revendication 4,
**caractérisé en ce que** la cadence d'échantillonnage du signal d'entrée est réduite dans un premier étage de décimation pour éliminer par filtrage les composantes à haute fréquence du signal.

**7.** Procédé selon la revendication 6,
**caractérisé en ce qu'**il est prévu, après le premier étage de décimation, un filtre coupe-bande destiné à supprimer la composante alternative de la tension du réseau.

8. Procédé selon la revendication 7,
**caractérisé en ce que**, dans un deuxième étage de décimation, la fréquence d'échantillonnage est réduite de manière supplémentaire afin d'effectuer un lissage supplémentaire du signal.

9. Procédé selon la revendication 8,
**caractérisé en ce que** d'autres filtres coupe-bande sont mis en oeuvre pour supprimer de manière supplémentaire la fréquence du réseau.

10. Dispositif de surveillance de l'isolement de réseaux électriques à courant continu et à courant alternatif non reliés à la terre qui présentent une résistance d'isolement ohmique ($R_f$) et capacitive ($C_f$) entre le réseau et la terre, comprenant une source de tension alternative impulsionnelle destinée à appliquer au réseau à surveiller une tension alternative impulsionnelle ($U_0$) qui présente en alternance différentes valeurs de tension impulsionnelle par l'intermédiaire d'un couplage de réseau ohmique ($R_i$) entre le réseau et la terre, et comportant un dispositif de surveillance destiné à surveiller la variation dans le temps du processus transitoire, qui dépend du réseau instantané, du courant de mesure ou d'une grandeur qui en découle, en tant que tension de mesure ($V_m$) pour chaque valeur de tension impulsionnelle ($U_0$),
**caractérisé en ce que** le dispositif comprend

- un dispositif de mesure destiné à détecter la variation dans le temps des processus transitoires de la tension de mesure ($V_m$) avant la transition du réseau à la valeur de tension impulsionnelle ($U_0$) respective de deux processus d'application de valeurs de tension impulsionnelle à polarité inversée, et
- un dispositif d'estimation de paramètres pour des paramètres de modèle d'une variation dans le temps calculée du processus transitoire de la tension de mesure ($V_m$) pour déterminer la résistance d'isolement ($R_f$) entre réseau et la terre, à partir d'un paramètre du modèle.

11. Dispositif selon la revendication 10, **caractérisé en ce que** le dispositif de mesure comprend un dispositif de filtrage destiné à effectuer un filtrage à cadences multiples au moyen de filtres de décimation récursifs.

12. Dispositif selon la revendication 11, **caractérisé en ce que** le dispositif de filtrage comprend un premier étage de décimation, un filtre coupe-bande et un deuxième étage de décimation.

Fig. 1

A ●→ | 101 (A/D) | → | 102 Dez | → | 103 Notch | → | 104 Dez | → | 105 Verz. |  B

(-)  ⊕

(-)  ⊕  C

| 201 Gen. | → | 202 Dez |  D

E

| 302 $\Lambda_0, O_0, A_0$ | ← | 301 Min. |

Fig. 2

13

**EP 2 433 147 B1**

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- EP 0654673 B1
- DE 10106200